# EUROPEAN PATENT APPLICATION

(11) **EP 4 617 768 A1**
(43) Date of publication of application: **17.09.2025**
(21) Application number: 23888020.7
(22) Date of filing: 07.11.2023
(51) Int. Cl.: G03B 15/06

(54) **OPTICAL PATH LIMITING ELEMENT AND DETECTION METHOD AND DEVICE USING SAME**

(30) Priority: 13.11.2022 CN 202211416593
(71) Applicant: Wuxi Autowell Technology Co., Ltd., Wuxi, Jiangsu 214000 (CN)
(72) Inventor: YAN, Dong, Wuxi, Jiangsu 214000 (CN); LI, Chang, Wuxi, Jiangsu 214000 (CN); HONG, Rui, Wuxi, Jiangsu 214000 (CN); WANG, Mei, Wuxi, Jiangsu 214000 (CN); XU, Fei, Wuxi, Jiangsu 214000 (CN); BIAN, Haifeng, Wuxi, Jiangsu 214000 (CN); XIAO, Wenlong, Wuxi, Jiangsu 214000 (CN); LI, Zetong, Wuxi, Jiangsu 214000 (CN); XUE, Dongdong, Wuxi, Jiangsu 214000 (CN); GU, Xiaoyi, Wuxi, Jiangsu 214000 (CN); HAN, Jie, Wuxi, Jiangsu 214000 (CN)
(74) Representative: Winter, Brandl - Partnerschaft mbB
(86) International application number: PCT/CN2023/130301
(87) International publication number: WO 2024/099331

(57) **Abstract**

The present disclosure discloses an optical path defining element, comprising a mounting base, a first reflective structure, and a second reflective structure, wherein the mounting base has an obliquely arranged mounting surface and an elongated hole, the elongated hole runs through the mounting base from the mounting surface and divides the mounting surface into a first mounting surface and a second mounting surface, the first mounting surface and the second mounting surface are respectively configured to mount the first reflective structure and the second reflective structure, the first reflective structure and the second reflective structure reflect light incident from an incident light source to the side edge of the object to be detected, and the light passes through the elongated hole to a detection camera after being reflected by the side edge of the object to be detected. According to The present disclosure, the problem of an existing square prism affecting an imaging effect can be effectively solved.

## Description

### TECHNICAL FIELD

The present disclosure relates to the field of silicon wafer sorting, and in particular, to an optical path defining element, and a detection method and device using the same.

### BACKGROUND ART

Before a silicon wafer is made into a cell, it is necessary to perform a series of defect detections on the silicon wafer, one of which is to detect a side edge of the silicon wafer.

In existing detection methods, a square prism is mostly used to reflect or transmit light from a light source, and part of the light transmitted by the square prism is reflected by a bottom of the square prism again, resulting in a too bright photographic background, which affects an imaging effect, thereby causing interference to side edge detection.

### SUMMARY OF THE INVENTION

In view of the problem of the use of a square prism for current side edge detection affecting an imaging effect, The present disclosure provides an optical path defining element, and a detection method and device using the same.

In a first aspect, The present disclosure provides an optical path defining element, which is configured to define a detection optical path on a side edge of an object to be detected, the optical path defining element comprising a mounting base, a first reflective structure, and a second reflective structure, wherein the mounting base has an obliquely arranged mounting surface and an elongated hole, the elongated hole runs through the mounting base from the mounting surface and divides the mounting surface into a first mounting surface and a second mounting surface, the first mounting surface and the second mounting surface are respectively configured to mount the first reflective structure and the second reflective structure, the first reflective structure and the second reflective structure reflect light incident from an incident light source to the side edge of the object to be detected, and the light passes through the elongated hole to a detection camera after being reflected by the side edge of the object to be detected.

The optical path defining element according to The present disclosure not only can reflect light, but also has the elongated hole that allows the light to pass through. Compared with a conventional square prism, if it is necessary to pass light through the optical path defining element, the light only needs to pass through the elongated hole without the need to pass through a transflective film of the square prism, and the light reflection from and light transmission through the optical path defining element can be implemented. Therefore, light reflection from a bottom of the square prism itself can be completely avoided, and the problem of an existing square prism affecting an imaging effect can be effectively solved.

Optionally, reflective surfaces of the first reflective structure and the second reflective structure are flat surfaces.

Optionally, the elongated hole has a width of 0.8-2 mm.

The width of the elongated hole is selected to be 0.8-2 mm, so that a matching relationship between the light source, the camera and a silicon wafer to be detected can be better balanced when a side edge of the silicon wafer is detected by using the optical path defining element according to The present disclosure, thereby improving the imaging effect of the side edge of the silicon wafer to be detected.

Optionally, an included angle between the obliquely arranged mounting surface and a horizontal plane is α, where 35° ≤ α ≤ 55°.

The included angle between the mounting surface and the horizontal plane is set to 35°-55°, facilitating the mounting of the reflective structures, and further facilitating the reflection of light from the reflective structures to the side edge of the silicon wafer to be detected.

Optionally, an included angle between the first reflective structure and the second reflective structure is β, where 150° ≤ β ≤ 180°.

The included angle between the first reflective structure and the second reflective structure is set to 150°-180°, so that the first reflective structure and the second reflective structure are arranged at an angle, and thus the light reflected by the first reflective structure to the side edge of the silicon wafer to be detected and the light reflected by the second reflective structure to the side edge of the silicon wafer to be detected intersect in the same area. This area corresponds to the elongated hole at a position of the side edge of the silicon wafer to be detected, so that the light that can be reflected by the silicon wafer and pass through the elongated hole is stronger, and thus the camera can capture a photo having a better imaging effect, thereby improving the detection accuracy of the side edge.

Optionally, one end of the first mounting surface away from the elongated hole is higher than the other end of the first mounting surface close to the elongated hole, one end of the second mounting surface away from the elongated hole is higher than the other end of the second mounting surface close to the elongated hole, and an included angle between the first mounting surface and the second mounting surface is consistent with the angle β.

The included angle between the first mounting surface and the second mounting surface is designed to be consistent with the angle β, which is more conducive to fixing the first reflective structure and the second reflective structure to the mounting surface, thereby facilitating mounting.

Optionally, the first reflective structure and the second reflective structure are respectively mounted on the first mounting surface and the second mounting surface in an angle adjustable manner.

The first reflective structure is mounted on the first mounting surface in an angle adjustable manner, and the second reflective structure is mounted on the second mounting surface in an angle adjustable manner, so that the included angle between the first reflective structure and the second reflective structure can be adaptively adjusted according to different detection environments, thereby improving the applicability of the optical path defining element.

Optionally, the first reflective structure and the second reflective structure are reflective mirrors or reflective films.

Either the reflective mirrors or the reflective films may be selected as the first reflective structure and the second reflective structure to reflect light, so that the fixation is convenient and the cost is controllable.

Optionally, an inner cavity of the optical path defining element is blackened, and the inner cavity comprises an inner wall of the elongated hole; and/or a non-mounting surface of the mounting base is blackened.

By blackening the inner cavity of the optical path defining element, part of the light entering the inner cavity can be absorbed, so as to avoid undesired reflection and refraction of the light in the inner cavity, which otherwise affects the imaging effect. By blackening the non-mounting surface of the mounting base, some stray light emitted by the light source can be absorbed to improve the imaging effect.

In a second aspect, The present disclosure provides a silicon wafer side edge detection method, comprising: directing light onto an optical path defining element as described above, reflecting the light by the optical path defining element to a side edge of a silicon wafer, and reflecting the light by the side edge of the silicon wafer and passing the light through the optical path defining element to a detection camera.

By using the optical path defining element according to The present disclosure to photograph the side edge of the silicon wafer, the problem of too bright background during photographing of the side edge of the silicon wafer in the prior art, which interferes with detection can be solved, thereby improving a final imaging effect of the detection camera.

Optionally, the step of reflecting the light by the optical path defining element to a side edge of a silicon wafer comprises:
reflecting part of the light to the side edge of the silicon wafer by the first reflective structure and/or reflecting part of the light to the side edge of the silicon wafer by the second reflective structure.

According to a specific situation of detection of the side edge of the silicon wafer, it is possible to flexibly choose to use only the first reflective structure to reflect part of light to the side edge of the silicon wafer, or use only the second reflective structure to reflect part of light to the side edge of the silicon wafer, or use both the first reflective structure and the second reflective structure to reflect part of light to the side edge of the silicon wafer. When only one reflective structure is required, the use of reflective structures can be saved, or when two reflective structures are used, the imaging effect can be improved, so that it is possible to adapt to silicon wafers with different qualities.

Optionally, the step of reflecting the light by the optical path defining element to a side edge of a silicon wafer comprises:
reflecting an overlap between part of the light reflected by the first reflective structure and part of the light reflected by the second reflective structure to the side edge of the silicon wafer.

The overlap between the part of the light reflected by the first reflective structure and the part of the light reflected by the second reflective structure is reflected to the side edge of the silicon wafer, that is, the side edge of the silicon wafer can receive both the light reflected by the first reflective structure and the light reflected by the second reflective structure, so that the side edge of the silicon wafer can receive enough light and reflect the light back to the detection camera, thereby improving the imaging effect.

Optionally, the step of reflecting the light by the side edge of the silicon wafer and passing the light through the optical path defining element to a detection camera comprises:
reflecting the light by the side edge of the silicon wafer and passing the light through the elongated hole to the detection camera.

Through the cooperation of the elongated hole, the light reflected by the side edge of the silicon wafer can reach the detection camera without hindrance.

In a third aspect, The present disclosure provides a silicon wafer detection device, comprising a conveying unit, an illumination unit, an optical path defining element as described above, an image acquisition unit, and an analysis unit, wherein the conveying unit is configured to convey a silicon wafer to be detected to a photographing area and convey the silicon wafer that has been subjected to photographing to a subsequent area; the illumination unit is configured to provide illumination to the silicon wafer to be detected; the optical path defining element is configured to reflect light emitted by the illumination unit to a side edge of the silicon wafer to be detected, and provide a channel for the light reflected by the side edge of the silicon wafer to enter the image acquisition unit; the image acquisition unit is configured to acquire an image of the side edge of the silicon wafer to be detected; and the analysis unit is configured to analyze the image of the side edge.

The silicon wafer detection device according to The present disclosure uses the optical path defining element according to The present disclosure, so that the problem of an existing square prism affecting an imaging effect can be effectively solved.

### BRIEF DESCRIPTION OF THE DRAWINGS

FIG. 1 is a schematic diagram of an implementation of an optical path defining element;
FIG. 2 is a schematic diagram of an optical path on a side edge of a silicon wafer during use of the optical path defining element of FIG. 1;
FIG. 3 is a schematic diagram of FIG. 1 with a first reflective structure and a second reflective structure hidden;
FIG. 4 is a schematic diagram of another implementation of an optical path defining element;
FIG. 5 is a simplified top view of the first reflective structure and the second reflective structure in FIG. 3;
FIG. 6 is a schematic diagram of an optical path using the optical path defining element of FIG. 1;
FIG. 7 is a schematic diagram of an optical path using the optical path defining element of FIG. 4;
FIG. 8 is a schematic diagram of an implementation of a silicon wafer detection device;
FIG. 9 is an image of a side edge of a silicon wafer photographed with a square prism being used for side edge detection in the prior art;
FIG. 10A is an image of a side edge of a silicon wafer photographed with an optical path defining element according to The present disclosure being used for side edge detection with an angle β of 180°;
FIG. 10B is an image of a side edge of a silicon wafer photographed with an optical path defining element according to The present disclosure being used for side edge detection with an angle β of 150°;
FIG. 10C is an image of a side edge of a silicon wafer photographed with an optical path defining element according to The present disclosure being used for side edge detection with an angle β of 145°; and
FIG. 10D is an image of a side edge of a silicon wafer photographed with an optical path defining element according to The present disclosure being used for side edge detection with an angle β of 140°.

### DETAILED DESCRIPTION OF EMBODIMENTS

To make the objective, technical solutions and advantages of embodiments of The present disclosure clearer, the technical solutions in The present disclosure are clearly and completely described below with reference to the accompanying drawings in the embodiments of The present disclosure. The described embodiments are some rather than all of the embodiments of The present disclosure. Thus, the following detailed description of the embodiments of The present disclosure provided in the accompanying drawings is not intended to limit the scope of The present disclosure as claimed, but is merely representative of the selected embodiments of The present disclosure.

The present disclosure is described in detail below with reference to the accompanying drawings and the embodiments. It should be noted that the embodiments in The present disclosure and features in the embodiments may be combined with each other without conflicts.

In existing chip surface detection, an arc-shaped/curved dome reflective mirror is used to uniformly reflect light from a light source onto a surface of a chip. Such an arc-shaped/curved light source has the advantages of a large illumination area and good uniformity, but this method is not suitable for adjusting a specific optical path direction and has strict requirements for a working distance. If the arc-shaped/curved light source is used to detect a side edge of a silicon wafer, due to a small working distance required by the light source, there are strict requirements for a mounting space, and it is very difficult to mount the light source. In addition, since there are saw marks on the side edge of the silicon wafer after cutting, if the arc-shaped/curved light source is used, based on the good uniformity of the light source, the saw marks are also imaged in the field of view of a camera, which is very detrimental to analysis of actual defects.

In current detection of the side edge of the silicon wafer, a square prism is mostly used to reflect or transmit light from a light source, and part of the light transmitted by the square prism is reflected by a bottom of the square prism again, resulting in a too bright photographic background, which affects an imaging effect, thereby causing interference to side edge detection.

In view of the problem of the use of a square prism for current side edge detection affecting an imaging effect, The present disclosure provides an optical path defining element, and a detection method and device using the same.

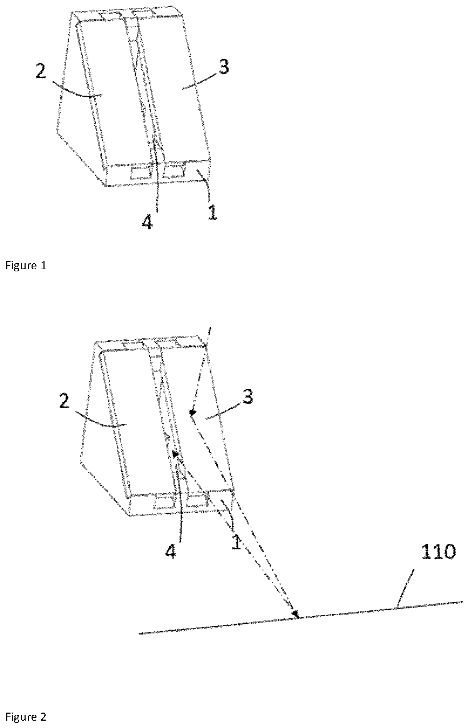

As shown in FIG. 1, The present disclosure provides an optical path defining element, which is configured to define a detection optical path on a side edge of an object to be detected. The detection optical path includes light that is incident from an incident light source, reaches the side edge of the object to be detected after being defined by the optical path defining element, and is sent to a detection camera by means of the optical path defining element. The optical path defining element comprises a mounting base 1, a first reflective structure 2, and a second reflective structure 3. The mounting base 1 has an obliquely arranged mounting surface and an elongated hole 4, and the elongated hole 4 runs through the mounting base 1 from the mounting surface and divides the mounting surface into a first mounting surface 5 and a second mounting surface 6. The first mounting surface 5 and the second mounting surface 6 are respectively configured to mount the first reflective structure 2 and the second reflective structure 3. The first reflective structure 2 and the second reflective structure 3 reflect the light incident from the incident light source to the side edge of the object to be detected, and the light passes through the elongated hole 4 to the detection camera after being reflected by the side edge of the object to be detected. The inclined surface of the mounting base 1 is obliquely arranged, which helps to provide corresponding mounting angles for the first reflective structure 2 and the second reflective structure 3 when the first reflective structure 2 and the second reflective structure 3 are being mounted, so as to cooperate with the first reflective structure 2 and the second reflective structure 3 to reflect the light incident from the incident light source.

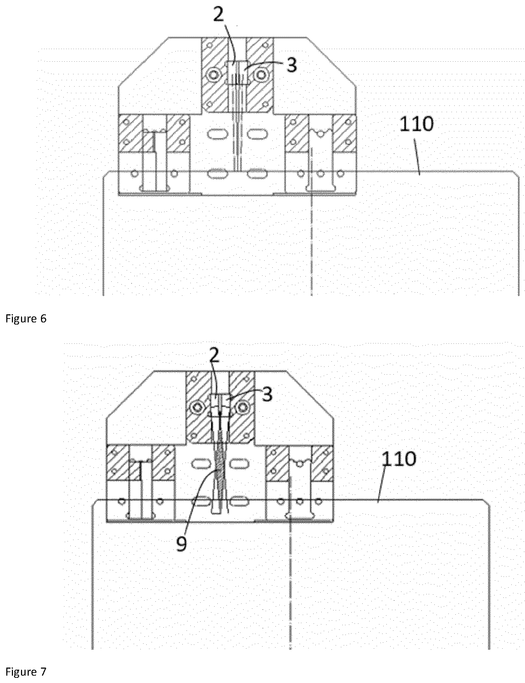

A working principle of applying the optical path defining element according to The present disclosure to the detection of a side edge of a silicon wafer is described in detail below with reference to FIGS. 2 and 6.

In a detection state, a side edge 110 of a silicon wafer to be detected is placed on a side of the optical path defining element, and the side edge 110 of the silicon wafer faces reflective surfaces of the first reflective structure 2 and the second reflective structure 3. The incident light source is arranged directly above the first reflective structure 2 and the second reflective structure 3 of the optical path defining element, and light emitted by the incident light source is directed to the first reflective structure 2 and the second reflective structure 3 of the optical path defining element. The detection camera is arranged collinearly with the elongated hole 4 and can receive the light transmitted through the elongated hole 4. With the second reflective structure 3 in FIG. 2 as an example, when light from the incident light source is directed to the second reflective structure 3, the second reflective structure 3 reflects the light from the light source onto the side edge 110 of the silicon wafer. Since the side edge itself of the silicon wafer has a light-reflecting ability, the light incident on the side edge 110 of the silicon wafer is reflected on the side edge 110 of the silicon wafer and is reflected out by the side edge 110 of the silicon wafer. Part of the light reflected out by the side edge 110 of the silicon wafer passes through the elongated hole 4 in the optical path defining element and reaches the detection camera, thereby allowing for the photographing of the side edge of the silicon wafer.

In the above detection process, the light is reflected to the side edge 110 of the silicon wafer by means of the optical path defining element, and part of the light reflected by the side edge 110 of the silicon wafer enters the detection camera through the elongated hole 4 of the optical path defining element, and this part of the light finally enters the detection camera through the elongated hole with a moderate intensity, so that the imaging of defects on the side edge 110 of the silicon wafer can be implemented, but the imaging of saw marks on the edge itself of the silicon wafer can be avoided. In addition, this part of the light has a moderate intensity, so that overexposure is prevented due to excessive illumination, which otherwise affects the imaging effect.

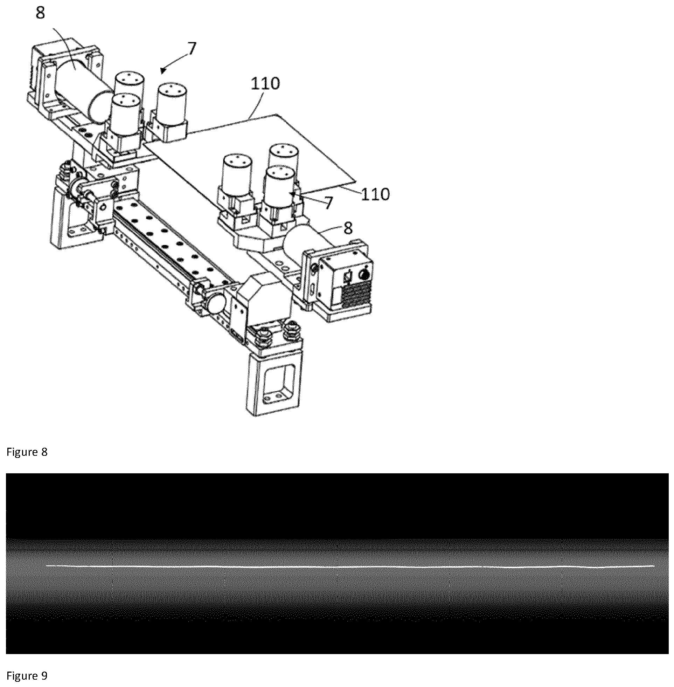

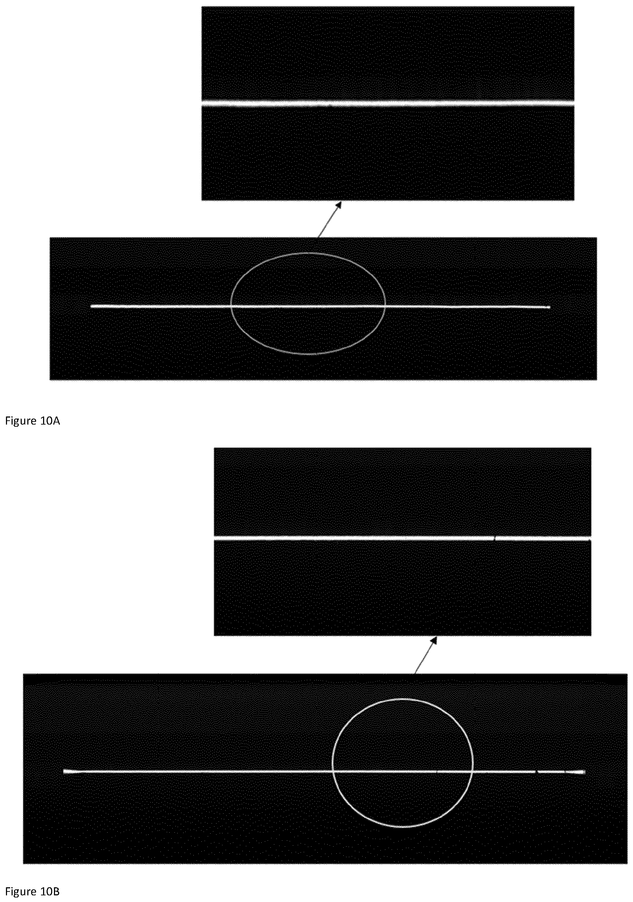

FIGS. 10A and 10B are images of a side edge of a silicon wafer photographed by using an optical path defining element according to The present disclosure. FIG. 9 is an image of a side edge of a silicon wafer photographed by using a square prism. It can be clearly seen that after the optical path defining element according to The present disclosure is used, the photographed images do not have the problem of too bright background is as in FIG. 9.

During detection of the side edge 110 of the silicon wafer, it is preferred to use a line scan camera, and the optical path defining element is arranged on a conveying path of the silicon wafer. During continuous travel of the silicon wafer, every part of the side edge 110 of the silicon wafer passes through the optical path defining element, so that the side edge 110 of the silicon wafer is subjected to photographing, and thus the detection efficiency of the side edge of the silicon wafer can be greatly improved. The elongated hole in the optical path defining element according to The present disclosure can better match the line scan camera to prevent the reflected light from being too stray due to a too large hole, which otherwise affects the imaging effect of the line scan camera.

During detection of the side edge 110 of the silicon wafer, a point light source is preferred, and the point light source provides enough light to meet requirements for the imaging of the side edge of the silicon wafer and is low in cost. In addition, the point light source is small in size and flexible in mounting form, facilitating the mounting of the light source and the adjustment of the position thereof.

A reflection principle of the first reflective structure 2 is the same as that of the second reflective structure 3 described above, and is not described in detail herein.

Although the principle is described above with reference to the detection of the side edge of the silicon wafer, the optical path defining element according to The present disclosure is not limited to the detection of the silicon wafer, and is also applicable to other sheet-like objects such as a semiconductor wafer and a cell.

The optical path defining element according to The present disclosure not only can reflect light, but also has the elongated hole 4 that allows the light to pass through. Compared with a conventional square prism, if it is necessary to pass light through the optical path defining element, the light only needs to pass through the elongated hole 4 without the need to pass through a transflective film of the square prism, and the light reflection from and light transmission through the optical path defining element can be implemented. Therefore, light reflection from a bottom of the square prism itself can be completely avoided, and the problem of an existing square prism affecting an imaging effect can be effectively solved.

When the elongated hole 4 has a width of 0.8-2 mm, a matching relationship between the light source, the camera and the silicon wafer to be detected can be better balanced, thereby improving the imaging effect of the side edge of the silicon wafer to be detected.

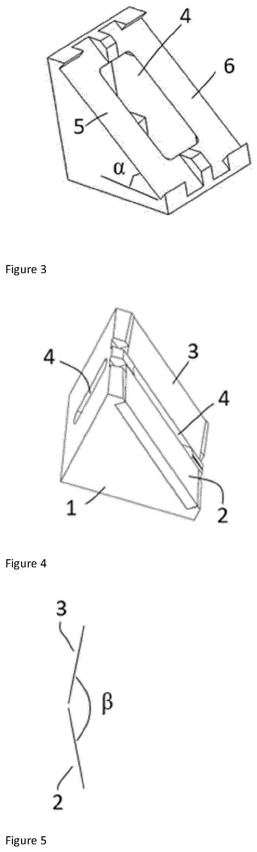

It should be noted that the width of the elongated hole 4 in the optical source defining element may be the width that has been confirmed during machining of the mounting base. This method is suitable for batch machining and also facilitates mounting. Alternatively, as shown in FIG. 3, during the machining of the mounting base, a wider hole may be provided in advance. Then, when the first reflective structure 2 and the second reflective structure 3 are being mounted, a mounting distance between the reflective structures is used to cover the wider hole appropriately. Then, the elongated hole 4 with the required width for the optical path defining element according to The present disclosure is formed. This method is more suitable for different detection scenarios and can flexibly adjust the width of the elongated hole based on the purpose of use.

As shown in FIG. 3, the mounting base 1 has an obliquely arranged mounting surface. In an optional implementation, an included angle between the mounting surface and a horizontal plane is α, where 35° ≤ α ≤ 55°.

There is a certain included angle between the mounting surface and the horizontal plane, and α may be 35°, 36°, 37°, 38°, 39°, 40°, 41°, 42°, 43°, 44°, 45°, 46°, 47°, 48°, 49°, 50°, 51°, 52°, 53°, 54°, or 55° in the above range, which is more helpful in improving the imaging effect and reducing the debugging difficulty.

The included angle between the mounting surface and the horizontal plane is set to 35°-55°, facilitating the mounting of the reflective structures, and further facilitating the reflection of light from the reflective structures to the side edge of the silicon wafer to be detected.

For a target to be detected that has a high light-reflecting ability, as shown in FIG. 3, the first reflective structure 2 and the second reflective structure 3 may be directly laid and fixed to the first mounting surface 5 and the second mounting surface 6. After the mounting, the positions of the first reflective structure 2 and the second reflective structure 3 on the mounting base are shown in FIG. 1.

As shown in FIG. 6, the first reflective structure 2 and the second light reflective structure 3 respectively reflect light to the side edge 110 of the silicon wafer. Since the side edge 110 of the silicon wafer has a high light-reflecting ability, the light reflected to the side edge 110 of the silicon wafer is reflected out by the side edge 110 of the silicon wafer. The light reflected out by the side edge 110 of the silicon wafer is indicated by a dashed-line area in FIG. 6, and the light that can pass through the elongated hole 4 can fully meet imaging requirements of the detection camera.

During detection of an object with a low light-reflecting ability, when the optical path defining element according to The present disclosure is used for optical path control, the detected object may reflect only a small amount of light back to the elongated hole, thereby affecting the imaging effect. To solve this problem and make the optical path defining element according to The present disclosure more applicable, optionally, as shown in FIGS. 4 and 5, an included angle between the first reflective structure 2 and the second reflective structure 3 is β, where 150° ≤ β ≤ 180°.

FIG. 10A illustrates an image of a side edge of a silicon wafer photographed with an optical path defining element according to The present disclosure being used for side edge detection with an angle β of 180°. It can be seen therefrom that the problem of too bright background is not present, and the side edge of the silicon wafer is imaged relatively clearly.

FIG. 10B illustrates an image of a side edge of a silicon wafer photographed with an optical path defining element according to The present disclosure being used for side edge detection with an angle β of 170°. It can be seen therefrom that the problem of too bright background is not present, and the side edge of the silicon wafer is imaged relatively clearly.

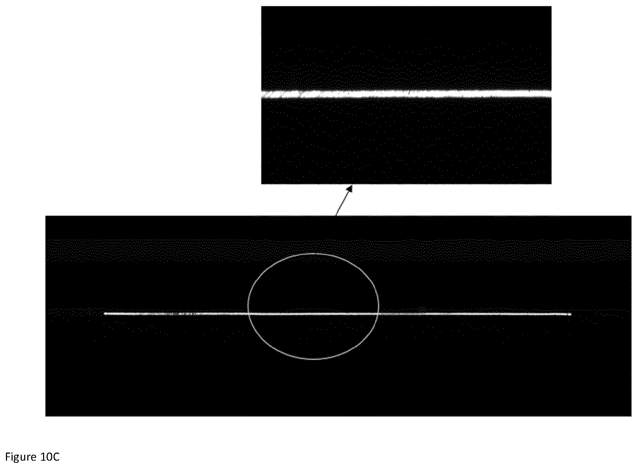

FIG. 10C illustrates an image of a side edge of a silicon wafer photographed with an optical path defining element according to The present disclosure being used for side edge detection with an angle β of 150°. It can be seen therefrom that in this case, although the problem of too bright background is not present, when the side edge of the silicon wafer is imaged, there are slight saw marks (as shown in the enlarged view) that do not affect image analysis.

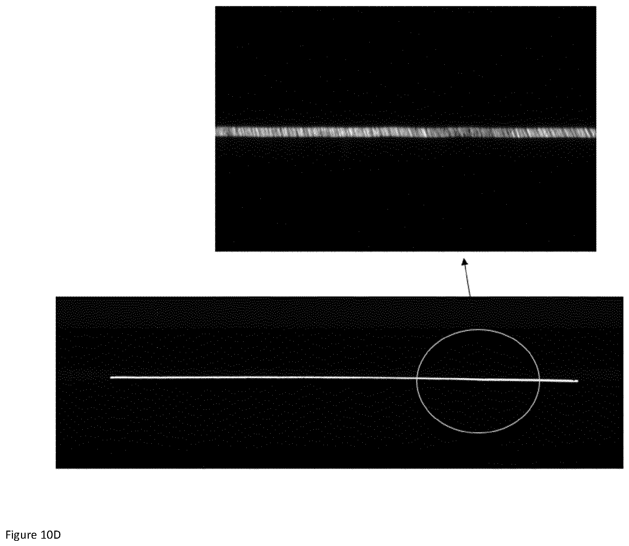

FIG. 10D illustrates an image of a side edge of a silicon wafer photographed with an optical path defining element according to The present disclosure being used for side edge detection with an angle β of 140°. It can be seen therefrom that in this case, although the problem of too bright background is not present, when the side edge of the silicon wafer is imaged, there are obvious saw marks (as shown in the enlarged view), and the saw marks seriously affect the accurate analysis of the image.

Therefore, the included angle between the first reflective structure 2 and the second reflective structure 3 is set to 150°-180°, so that the first reflective structure 2 and the second reflective structure 3 are arranged at an angle, and thus the light reflected by the first reflective structure 2 to the side edge of the silicon wafer to be detected and the light reflected by the second reflective structure 3 to the side edge of the silicon wafer to be detected intersect in the same area 9. This area 9 corresponds to the elongated hole 4 at a position of the side edge of the silicon wafer, so that the light that can be reflected by the side edge of the silicon wafer and pass through the elongated hole 4 is stronger, and thus the camera can capture a photo having a better imaging effect, thereby improving the detection accuracy of the side edge.

When the included angle β is formed between the first reflective structure 2 and the second reflective structure 3, the first mounting surface 5 and the second mounting surface 6 may be specially designed to facilitate the mounting of the first reflective structure 2 and the second reflective structure 3.

Specifically, as shown in FIG. 4, one end of the first mounting surface 5 away from the elongated hole 4 is higher than the other end of the first mounting surface 5 close to the elongated hole 4, one end of the second mounting surface 6 away from the elongated hole 4 is higher than the other end of the second mounting surface 6 close to the elongated hole 4, and an included angle between the first mounting surface 5 and the second mounting surface 6 is consistent with the angle β.

When the included angle β is formed between the first reflective structure 2 and the second reflective structure 3, in order to make multiple optional and adjustable included angles exist between the first reflective structure 2 and the second reflective structure 3, optionally, the first reflective structure 2 and the second reflective structure 3 are respectively mounted on the first mounting surface 5 and the second mounting surface 6 in an angle adjustable manner.

Specifically, the first reflective structure 2 and the second reflective structure 3 may be respectively fixedly mounted on two rotating shafts, and the two rotating shafts are respectively rotatably mounted on the mounting base, so that the adjustment of the angle between the first reflective structure 2 and the second reflective structure 3 can be achieved by rotating the rotating shafts. Of course, in order to make the angle adjustment more accurate, a scale may be alternatively provided on the mounting base.

Further, in order to achieve synchronous angle adjustment between the first reflective structure 2 and the second reflective structure 3, pinions with the same specifications that mesh with each other may be arranged at ends of the two rotating shafts.

The first reflective structure 2 is mounted on the first mounting surface 5 in an angle adjustable manner, and the second reflective structure 3 is mounted on the second mounting surface 6 in an angle adjustable manner, so that the included angle between the first reflective structure 2 and the second reflective structure 3 can be adaptively adjusted according to different detection environments, thereby improving the applicability of the optical path defining element.

Optionally, reflective surfaces of the first reflective structure 2 and the second reflective structure 3 are flat surfaces. The use of the reflective surfaces that are flat surfaces helps to reflect the light incident from the incident light source to the side edge 110 of the silicon wafer at a required reflection angle, so that the reflection angle is better controlled. However, for other reflective surfaces (especially arc-shaped/curved reflective surfaces) that are not flat surfaces, after the light from the incident light source is incident on the reflective surfaces, reflection angles of light at different parts of the reflective surfaces are different, so that it is impossible to control the angles of the light reflected by the reflective surfaces that are not flat surfaces, which is very detrimental to detection of the side edge 110 of the silicon wafer.

When the first reflective structure 2 and the second reflective structure 3 with flat reflective surfaces are used, sheet-like reflective structures each having a certain thickness may be selected, and may preferentially match the obliquely arranged first mounting surface 5 and second mounting surface 6 during mounting. The sheet-like first reflective structure 2 and sheet-like second reflective structure 3 are respectively mounted on the first mounting surface 5 and the second mounting surface 6, so that the reflective surfaces of the first reflective structure 2 and the second reflective structure 3 on the mounting base 1 have inclined angles. Such a structure of the optical path defining element is easier to machine and assemble.

When the first reflective structure 2 and the second reflective structure 3 with flat reflective surfaces are used, the included angle β between the first reflective structure 2 with a reflective surface and the second reflective structure 3 with a reflective surface is the included angle between the reflective surface of the first reflective structure 2 and the reflective surface of the second reflective structure 3.

Optionally, the first reflective structure 2 and the second reflective structure 3 are reflective mirrors or reflective films.

Either the reflective mirrors or the reflective films may be selected as the first reflective structure 2 and the second reflective structure 3 to reflect light, so that the fixation is convenient and the cost is controllable.

Optionally, an inner cavity of the optical path defining element is blackened, and the inner cavity in The present disclosure comprises an inner wall of the elongated hole 4. The inner wall mainly refers to all inner surfaces of the elongated hole in the mounting base.

Specifically, blackening may include applying a black layer to the inner cavity, applying black light absorption cotton, or other similar treatments that can make the inner cavity absorb light.

By blackening the inner cavity of the optical path defining element, part of the light entering the inner cavity can be absorbed, so as to avoid undesired reflection and refraction of the light in the inner cavity, which otherwise affects the imaging effect.

Optionally, the non-mounting surface of the mounting base that the elongated hole runs through is blackened. By blackening the non-mounting surface of the mounting base, some stray light emitted by the light source can be absorbed to improve the imaging effect.

The non-mounting surface of the mounting base includes any surface or a combination of any two or more surfaces other than the first mounting surface and the second mounting surface.

When an external light source incident light source is arranged directly above the first reflective structure 2 and the second reflective structure 3, the light emitted by the light source mainly illuminates the first reflective structure 2 and the second reflective structure 3, a small part of the light may also illuminate three side surfaces adjacent to the reflective structure as shown in FIG. 4. In this case, it is preferable to blacken the three side surfaces.

When the detection camera is arranged on a side collinear with the elongated hole 4 and facing away from the first reflective structure 2 and the second reflective structure 3, the light emitted by the incident light source may be directed to the non-mounting surface corresponding to the detection camera. In this case, it is preferable to blacken the non-mounting surface corresponding to the detection camera to prevent the non-mounting surface corresponding to the detection camera from reflecting stray light into the detection camera, which otherwise affects the detection effect.

In a second aspect, The present disclosure provides a silicon wafer side edge detection method, comprising, as shown in FIG. 2: directing light onto an optical path defining element according to The present disclosure, reflecting the light by the optical path defining element to a side edge of a silicon wafer, and reflecting the light by the side edge of the silicon wafer and passing the light through the optical path defining element to a detection camera.

By using the optical path defining element according to The present disclosure to photograph the side edge of the silicon wafer, the problem of too bright background during existing photographing of the side edge of the silicon wafer, which interferes with detection can be solved, thereby improving a final imaging effect of the detection camera.

Optionally, the step of reflecting the light by the optical path defining element to a side edge of a silicon wafer comprises:
reflecting part of the light to the side edge of the silicon wafer only by the first reflective structure 2; or
reflecting part of the light to the side edge of the silicon wafer only by the second reflective structure 3;
   or
reflecting part of the light to the side edge of the silicon wafer by both the first reflective structure 2 and the second reflective structure 3.

It should be noted that the above three ways of reflecting light to the side edge of the silicon wafer by the optical path defining element can be applied to the case where the included angle β between the first reflective structure 2 and the second reflective structure 3 in The present disclosure is 150°, or 180°, or any value in the range of 150°-180°.

According to a specific situation of detection of the side edge of the silicon wafer, it is possible to flexibly choose to use only the first reflective structure 2 to reflect part of light to the side edge of the silicon wafer, or use only the second reflective structure 3 to reflect part of light to the side edge of the silicon wafer, or use both the first reflective structure 2 and the second reflective structure 3 to reflect part of light to the side edge of the silicon wafer. When only one reflective structure is required, the use of reflective structures can be saved, or when two reflective structures are used, the imaging effect can be improved, so as to adapt to silicon wafers with different qualities.

Optionally, the step of reflecting the light by the optical path defining element to a side edge of a silicon wafer comprises,
as shown in Fig. 7: reflecting an overlap 9 between part of the light reflected by the first reflective structure 2 and part of the light reflected by the second reflective structure 3 to the side edge of the silicon wafer.

The overlap between the part of the light reflected by the first reflective structure 2 and the part of the light reflected by the second reflective structure 3 is reflected to the side edge of the silicon wafer, that is, the side edge of the silicon wafer can receive both the light reflected by the first reflective structure 2 and the light reflected by the second reflective structure 3, so that the side edge of the silicon wafer can receive enough light and reflect the light back to the detection camera, thereby improving the imaging effect.

Optionally, the step of reflecting the light by the side edge of the silicon wafer and passing the light through the optical path defining element to a detection camera comprises:
reflecting the light by the side edge of the silicon wafer and passing the light through the elongated hole 4 to the detection camera.

Through the cooperation of the elongated hole 4, the light reflected by the side edge of the silicon wafer can reach the detection camera without hindrance.

In a third aspect, as shown in FIG. 8, The present disclosure provides a silicon wafer detection device, comprising a conveying unit, an illumination unit 7, an optical path defining element according to The present disclosure, an image acquisition unit 8, and an analysis unit. The conveying unit is configured to convey a silicon wafer to be detected to a photographing area and convey the silicon wafer that has been subjected to photographing to a subsequent area; the illumination unit 7 is configured to provide illumination to the silicon wafer to be detected; the optical path defining element is configured to reflect light emitted by the illumination unit to a side edge of the silicon wafer to be detected, and provide a channel for the light reflected by the side edge of the silicon wafer to enter the image acquisition unit 8; the image acquisition unit 8 is configured to acquire an image of the side edge of the silicon wafer to be detected; and the analysis unit is configured to analyze the image of the side edge.

Specifically, as shown in FIG. 8, an illumination unit 7, an optical path defining element and an image acquisition unit 8 as a group are provided on each of two sides of the conveying unit for detecting the side edge of the silicon wafer. With one side of the conveying unit as an example, the image acquisition unit 8 comprises a camera, the camera and the optical path defining element are collinearly arranged, and an optical axis of the camera and a corresponding central line of an elongated hole 4 are collinearly provided. A point light source is selected as the illumination unit 7, which is arranged directly above the optical path defining element and opposite to the first reflective surface 2 and/or the second reflective surface 3 of the optical path defining element.

When the conveying unit carries and conveys a silicon wafer to be detected to a photographing area, light emitted by the point light source is directed to the first reflective surface structure 2 and/or the second reflective surface structure 3 of the optical path defining element, the first reflective structure surface 2 and/or the second reflective structure surface 3 reflects the received light to the side edge of the silicon wafer at a certain angle, and the side edge of the silicon wafer reflects the light outwardly and passes the light through the elongated hole 4 of the optical path defining element to enter the camera, thereby achieving image acquisition of the side edge of the silicon wafer.

The silicon wafer detection device according to The present disclosure uses the optical path defining element according to The present disclosure, so that the problem of an existing square prism affecting an imaging effect can be effectively solved, thereby improving the detection effect of the side edge of the silicon wafer.

The present disclosure and the implementation thereof have been described schematically above, and the description is not restrictive. Only one of the implementations of The present disclosure is shown in the drawings, but the actual structure is not limited thereto. Therefore, with the motivation from The present disclosure, any structural forms and embodiments similar to the technical solution, which are designed by those of ordinary skill in the art without involving any inventive effect and deviating from the essence of The present disclosure, shall all fall within the scope of protection of The present disclosure.

## Claims

1. An optical path defining element, which is configured to define a detection optical path on a side edge of an object to be detected, the optical path defining element comprising a mounting base, a first reflective structure, and a second reflective structure, wherein the mounting base has an obliquely arranged mounting surface and an elongated hole, the elongated hole runs through the mounting base from the mounting surface and divides the mounting surface into a first mounting surface and a second mounting surface, the first mounting surface and the second mounting surface are respectively configured to mount the first reflective structure and the second reflective structure, the first reflective structure and the second reflective structure reflect light incident from an incident light source to the side edge of the object to be detected, and the light passes through the elongated hole to a detection camera after being reflected by the side edge of the object to be detected.

2. The optical path defining element according to claim 1, wherein reflective surfaces of the first reflective structure and the second reflective structure are flat surfaces.

3. The optical path defining element according to claim 1, wherein the elongated hole has a width of 0.8-2 mm.

4. The optical path defining element according to claim 1, wherein an included angle between the obliquely arranged mounting surface and a horizontal plane is α, where 35° ≤ α ≤ 55°.

5. The optical path defining element according to claim 1, wherein an included angle between the first reflective structure and the second reflective structure is β, where 150° ≤ β ≤ 180°.

6. The optical path defining element according to claim 5, wherein one end of the first mounting surface away from the elongated hole is higher than the other end of the first mounting surface close to the elongated hole, one end of the second mounting surface away from the elongated hole is higher than the other end of the second mounting surface close to the elongated hole, and an included angle between the first mounting surface and the second mounting surface is consistent with the angle β.

7. The optical path defining element according to claim 5, wherein the first reflective structure and the second reflective structure are respectively mounted on the first mounting surface and the second mounting surface in an angle adjustable manner.

8. The optical path defining element according to claim 1, wherein the first reflective structure and the second reflective structure are reflective mirrors or reflective films.

9. The optical path defining element according to claim 1, wherein an inner cavity of the optical path defining element is blackened, and the inner cavity comprises an inner wall of the elongated hole;
and/or a non-mounting surface of the mounting base is blackened.

10. A silicon wafer side edge detection method, comprising: directing light onto an optical path defining element according to any one of claims 1-9, reflecting the light by the optical path defining element to a side edge of a silicon wafer, and reflecting the light by the side edge of the silicon wafer and passing the light through the optical path defining element to a detection camera.

11. The silicon wafer side edge detection method according to claim 10, wherein the step of reflecting the light by the optical path defining element to a side edge of a silicon wafer comprises:
reflecting part of the light to the side edge of the silicon wafer by the first reflective structure and/or reflecting part of the light to the side edge of the silicon wafer by the second reflective structure.

12. The silicon wafer side edge detection method according to claim 10, wherein the step of reflecting the light by the optical path defining element to a side edge of a silicon wafer comprises:
reflecting an overlap between part of the light reflected by the first reflective structure and part of the light reflected by the second reflective structure to the side edge of the silicon wafer.

13. The silicon wafer side edge detection method according to claim 10, wherein the step of reflecting the light by the side edge of the silicon wafer and passing the light through the optical path defining element to a detection camera comprises:
reflecting the light by the side edge of the silicon wafer and passing the light through the elongated hole to the detection camera.

14. A silicon wafer detection device, comprising a conveying unit, an illumination unit, an optical path defining element according to any one of claims 1-9, an image acquisition unit, and an analysis unit, wherein the conveying unit is configured to convey a silicon wafer to be detected to a photographing area and convey the silicon wafer that has been subjected to photographing to a subsequent area; the illumination unit is configured to provide illumination to the silicon wafer to be detected; the optical path defining element is configured to reflect light emitted by the illumination unit to a side edge of the silicon wafer to be detected, and provide a channel for the light reflected by the side edge of the silicon wafer to enter the image acquisition unit; the image acquisition unit is configured to acquire an image of the side edge of the silicon wafer to be detected; and the analysis unit is configured to analyze the image of the side edge.
